# EUROPÄISCHE PATENTSCHRIFT

(11) **EP 2 650 076 B1**
(45) Veröffentlichungstag und Bekanntmachung des Hinweises auf die Patenterteilung: **14.02.2018**
(21) Anmeldenummer: 13162777.0
(22) Anmeldetag: 08.04.2013
(51) Int. Cl.: B23K 26/00, B23K 26/06, B23K 26/073, B23K 26/36, C03B 33/09, C03B 33/10, H01L 21/78, H01L 31/18

(54) **Verfahren und Vorrichtung zum Einbringen von Trennrissen in ein Substrat unter Verwendung einer eine starre Blendenöffnung aufweisenden starren Blende**
Method and device for inserting separating cracks into a substrate using a fixed blade with a fixed opening
Procédé et dispositif d'introduction de fissures de séparation dans un substrat utilisant une lame fixe ayant une ouverture fixe

(30) Priorität: 12.04.2012 DE 102012103176
(43) Veröffentlichungstag der Anmeldung: 16.10.2013
(73) Patentinhaber: JENOPTIK Automatisierungstechnik GmbH, 07745 Jena (DE)
(72) Erfinder: Nawrodt, Sebastian, 07629 Hermsdorf (DE); Ullmann, Ronny, 07751 Rothenstein (DE); Heinig, Karsten, 07548 Gera (DE); Matthies, Christian, 07774 Camburg (DE); Weißer, Jürgen, 07743 Jena (DE)
(74) Vertreter: Schaller, Renate

(56) Entgegenhaltungen:
- JP-A- 2002 292 489
- US-A1- 2006 163 223
- US-B1- 6 327 875

## Beschreibung

Die Erfindung betrifft ein Verfahren zum Einbringen von Trennrissen in ein Substrat unter Einwirkung eines Laserstrahles mit einer elliptischen Strahlquerschnitt gemäß dem Oberbegriff des Anspruchs 1. Die Erfindung betrifft auch eine Vorrichtung zur Durchführung des Verfahrens gemäß dem Oberbegriff des Anspruchs 3, siehe US6 327 875 B1 für beide Oberbegriffe. Aus dem Stand der Technik sind unterschiedliche Verfahren für das Einbringen von Trennrissen in Substratoberflächen bekannt. Mit der Offenlegungsschrift DE 10 2008 000 418 A1 wird ein Verfahren offenbart, bei dem die Oberfläche eines Bauteils mittels Strahlung einer Laser- oder Infrarotstrahlquelle entlang einer Sollbruchlinie lokal erhitzt wird. Die Einleitung der Strahlungsenergie erfolgt dabei asymmetrisch, wobei die Sollbruchlinie in kurzen Zeitabständen mit zwei gleich oder unterschiedlich starken Strahlungsenergien beaufschlagt wird. Zusammen mit einer anschließend durchgeführten, schockartigen Abkühlung erfolgt die Ausbildung eines Trennrisses entlang der Sollbruchlinie.

Ein in der DE 43 05 107 A1 beschriebenes Verfahren zum Schneiden spröder Körper nutzt Laserstrahlung zur Erwärmung der Oberfläche des Körpers entlang einer Schnittlinie. Die sich dadurch aufbauende thermomechanische Spannung führt zum Bruch des Körpers entlang der Schnittlinie. Der auf die Oberfläche einwirkende Strahlquerschnitt des Laserstrahls ist länglich geformt und entlang der Schnittlinie ausgerichtet. Die Länge und Breite des Strahlquerschnitts wird über eine Optik geformt, wobei die Länge über verstellbare Blenden zusätzlich begrenzt werden kann.

Bei dem in der WO 96/20062 A1 aufgezeigten Laserverfahren und der dafür geeigneten Vorrichtung, wird durch das Einbringen einer lokal begrenzten thermoelastischen Spannung ein geführter, oberflächlicher Trennriss im Material erzeugt, entlang dem das Substrat anschließend gebrochen werden kann. Die thermischen Spannungen entstehen zwischen einer lokal, mit geeigneter Laserstrahlung aufgeheizten Zone der Substratoberfläche, in der Druckspannungen generiert werden, und einer nachfolgenden, mit einem gerichteten Kühlmittelstrahl realisierten, schockartigen Abkühlung, durch welche Zugspannungen generiert werden. Wird der Bereich der größten Spannungsdifferenz, ausgehend von einem künstlich erzeugten initiierenden Defekt, relativ zur Substratoberfläche bewegt, entsteht der geführte Trennriss. Ein entlang dieses Trennrisses gebrochenes Substrat weist eine qualitativ hochwertige Bruchkante auf, die, gegenüber den konventionellen Ritz- und Brech-Verfahren mit Hartmetallrädchen oder Diamant, völlig frei von Kantenschäden ist.

Die in der vorgenannten WO96/20062 A1 offenbarte Vorrichtung umfasst eine geeignete Laserstrahlquelle, deren Strahlung teilweise vom Substrat absorbiert wird, sodass eine lokale Erwärmung erfolgen kann. Die Laserstrahlung wird auf die Substratoberfläche gerichtet. Mit einer strahlformenden Optik wird die Laserstrahlung auf der Substratoberfläche zu einem elliptischen Strahlfleck geformt, wobei die in Richtung der Relativbewegung orientierte Hauptachse der Ellipse eine vielfache Länge der quer zur Relativbewegung orientierten Nebenachse aufweist. Zur Erzeugung der Spannungsdifferenz ist dem elliptischen Strahlfleck der Auftreffpunkt des gerichteten Kühlmittelstrahls in Richtung der Relativbewegung nachfolgend angeordnet. Die Relativbewegung zwischen der Optik mit dem nachgeordneten Kühlmittelstrahl und dem Substrat wird ebenfalls mit der Vorrichtung realisiert. Dazu wird das Substrat gegenüber der Optik linear bewegt. Die gezielte Einstellung von Prozessparametern, wie Bewegungsgeschwindigkeit, Laserleistung, Strahlfleckformung und Kühlparameter, ermöglicht eine gezielte Beeinflussung der Trennrissausbildung.

In der Offenlegungsschrift DE 10 2007 033 242 A1 wird das Grundprinzip des zuvor erläuterten Verfahrens dazu verwendet, ein flaches Substrat in mehrere, beliebig große, rechteckige Zuschnitte zu trennen. Das erfolgt durch Einbringen von sich vorzugsweise orthogonal kreuzenden Trennrissen, die in einer ersten und in einer zweiten Bearbeitungsrichtung eingebracht werden. Die Trennrisse werden stets an einem initiierenden, künstlich eingebrachten Defekt an einer Substrataußenkante gestartet und enden auch wieder an einer Substrataußenkante. Die Bearbeitung erfolgt auf der Oberseite von auf einer horizontal orientierten Auflagefläche abgelegten, vorzugsweise kleinen Substraten mit den üblichen Abmessungen von Halbleiter-Wafern. Die Relativbewegung zwischen der Optik und dem Substrat erfolgt durch eine Bewegung der Auflagefläche und damit auch des aufliegenden Substrats auf einer Linearachse der Vorrichtung. Zur Einstellung der zweiten Bearbeitungsrichtung wird das Substrat um eine senkrecht stehende Rotationsachse der Vorrichtung gedreht. Die Relativbewegung zum Einbringen des Trennrisses in der zweiten Bearbeitungsrichtung erfolgt danach mit der gleichen Linearachse wie für die erste Bearbeitungsrichtung. Bei größeren Substraten, beispielsweise Flachglassubstraten mit den standardisierten Abmessungen einer Floatglas-Produktion, die in zwei Bearbeitungsrichtungen mit Trennrissen versehen werden sollen, wäre die Relativbewegung und die Rotation des Substrats gegenüber der Optik durch Bewegung der Auflagefläche oder des Substrats selbst nur mit einem hohen konstruktiven Aufwand und entsprechend großem Platzbedarf zu realisieren.

Mit der in der Offenlegungsschrift DE 10 2005 027 800 A1 veröffentlichen Vorrichtung lässt sich das zuvor genannte Problem der Rotationsbewegung lösen. Zur Realisierung der vorzugsweise orthogonal zur ersten Bearbeitungsrichtung orientierten zweiten Bearbeitungsrichtung ist hier die Optik in einem Bearbeitungskopf integriert, mit dem der Strahlfleck und der zum Strahlfleck ausgerichtete Kühlmittelstrahl synchron um eine senkrechte Rotationsachse gedreht werden kann. Um die Relativbewegung in beiden Bearbeitungsrichtungen zu erzeugen, ist es erforderlich, dass eine orthogonal zur Ersten ausgerichtete zweite Linearachse vorhanden ist, mit der das Substrat bewegt werden kann.

Als ein weiterer Vorteil gegenüber der Vorrichtung aus der DE 10 2007 033 242 A1, ist in der vorgenannten DE 10 2005 027 800 A1 die Verwendung von zwei gerichteten Kühlmittelstrahlen zu sehen. Dazu ist an beiden Enden der Hauptachse des elliptischen Strahlflecks, symmetrisch zur Strahlachse, jeweils ein Kühlmittelstrahl angeordnet. Diese Anordnung ermöglicht die Bearbeitung des Substrats in einer Bearbeitungsrichtung mit wechselndem Richtungssinn, indem immer nur der jeweils dem Strahlfleck in Bearbeitungsrichtung nachfolgende Kühlmittelstrahl verwendet wird. Somit können Trennrisse von sich gegenüberliegenden Substratkanten wechselweise eingebracht werden. Auch bei dieser Vorrichtung erfolgt die Relativbewegung durch Bewegen des Substrats bzw. der Auflagefläche. Es kann somit davon ausgegangen werden, dass auch hier nur Substrate von geringen Abmessungen bearbeitete werden.

Die Verwendung der Vorrichtung sieht vor, dass ein Trennriss immer von einem initiierenden Defekt ausgehend, an einer Substrataußenkante beginnt und auch an einer Substrataußenkante endet. Aus diesem Grund wird die Relativbewegung so ausgeführt, dass die entsprechende Linearachse immer von einem vorgegebenen Startpunkt zu einem vorgegebenen Zielpunkt bewegt wird. Damit an den Anfangs- und Endpunkten der Trennrisse die notwendige thermoelastische Spannung zur Erzeugung der Trennrisse erreicht wird, müssen diese Punkte von der kompletten Länge des in der Hauptachse ausgedehnten elliptischen Strahlflecks und vom Kühlmittelstrahl erfasst werden. Deshalb müssen die Start- und Zielpunkte der Linearachsen so vorgegeben werden, dass der gesamte Strahlfleck an den Anfangs- und Endpunkten des Trennrisses stets außerhalb des Substrats liegt. Die Vorrichtung ist steuerungstechnisch nicht dafür vorgesehen, einen Trennriss beispielsweise mittig auf der Substratoberfläche beginnen oder enden zu lassen.

Durchgängige Trennrisse führen außerdem dazu, dass zwischen zwei in einer Bearbeitungsrichtung benachbarten Trennrissen nur Zuschnitte erstellt werden können, deren jeweils in der ersten und zweiten Bearbeitungsrichtung orientierten Kanten die gleiche Länge aufweisen wie die der in der entsprechenden Richtung benachbarten Zuschnitte. Es ist deshalb nicht möglich aus einem Substrat Zuschnitte herzustellen, die sich zumindest in einer Bearbeitungsrichtung von den Kantenlängen benachbarter Zuschnitte unterscheiden.

Für bestimmte technologische Anwendungen wäre es von Vorteil, wenn Trennrisse an beliebigen Stellen der Substratoberfläche anfangen und enden könnten. So ließe sich beispielsweise durch verschachtelt angeordnete Zuschnitte bedarfsgerecht eine optimale Ausnutzung der Substratflächen erreichen. Eine verschachtelte Anordnung hat zur Folge, dass Anfangs- und Endpunkte von Trennrissen in einer Bearbeitungsrichtung an Trennrissen in der anderen Bearbeitungsrichtung liegen können und somit ein T-förmiger Schnittpunkt entsteht. Wie oben bereits erwähnt, setzt die Verwendung der aus dem bisherigen Stand der Technik ermittelten Vorrichtungen und Verfahren voraus, dass der Anfangs- und Endpunkt eines Trennrisses mit der kompletten, in der Hauptachse ausgedehnten Länge des elliptischen Strahlflecks und von dem Kühlmittelstrahl überfahren werden muss. Bei sehr langen elliptischen Strahlflecken ist deshalb auch die zu überfahrende Strecke sehr lang. Daraus ergibt sich bei T-förmigen Schnittpunkten das Problem, dass der quer zur Bearbeitungsrichtung liegende Trennriss und der anschließende, nicht zu trennende Abschnitt des Substrats vom Strahlfleck beaufschlagt wird. Dadurch können im nachfolgenden Brechprozess Brechfehler entstehen und der quer zur Bearbeitungsrichtung liegende Zuschnitt beschädigt werden.

In der Patentschrift US 6 327 875 B1 ist ein Verfahren offenbart, in dem, beginnend und endend an einer Substrataußenkante, ein Trennriss in die Oberfläche eines Glassubstrats eingebracht wird. Dazu wird ein Laserstrahl mit einem elliptischen Querschnitt verwendet, dessen große Halbachse entlang des Trennrisses ausgerichtet und während des Verfahrens mittels einer festen Blende auf eine bestimmte verbleibende Ellipsenlänge entlang der großen Halbachse beschnitten wird. Vor Beginn des Verfahrens kann durch Änderung der Größe der Blendenöffnung die Blende an unterschiedliche Ellipsenlängen angepasst werden. Mit dem Beschneiden der Ellipsenlänge werden die energetisch abfallenden Enden abgeschnitten, womit der Laserstrahl entlang der verbleibenden Ellipsenlänge eine im Wesentlichen konstante Energieverteilung, auch Tophat- Verteilung genannt, aufweist.

Die Offenlegungsschrift US 2006/163223 A1 beschreibt ein Verfahren zur thermischen Behandlung von Halbleiterwafern mittels Laserstrahl. Dabei wird auf dem Wafer eine Laserlinie mit einem elliptischen Querschnitt abgebildet und in Richtung ihrer kleinen Halbachse relativ über die Waferoberfläche gescannt. Mit einem solchen Verfahren kann die Oberfläche des Wafers auf eine hohe Temperatur erwärmt werden, um z. B. Dotanten im Substrat des Halbleiterwafers zu aktivieren. Es wird darauf hingewiesen, dass ein solches Verfahren einen sehr gleichmäßigen Energieeintrag bewirken muss, bei dem thermische Spannungen im Substrat gering gehalten werden, um Risse im Substrat zu vermeiden. Damit auf der Oberfläche des Substrates nur eine innenliegende Produktzone und nicht ein diese umschließender Randbereich erwärmt wird, wird der Laserstrahl durch eine Aperturblende mit einer verstellbaren Blendenöffnung beschnitten. Im Falle, dass das Substrat gekrümmte Kanten aufweist, wird der Betrag des Beschneidens synchron mit der Scanposition und senkrecht zur Scanrichtung verändert.

Die JP 2002 292489 A beschreibt ein Verfahren, in dem eine vorgegebene Struktur mit verschiedenen Strukturbereichen A, B, C (siehe JP 2002 292489 A, Fig. 2) mittels Laser auf ein in einer Bildebene eines optischen Systems angeordnetes Substrat projiziert wird, wobei in einer Zwischenbildebene eine Maske mit einem in einer Richtung gestauchten transparenten Abbild der vorgegebenen Struktur angeordnet ist. Um die Struktur auf dem Substrat zu bilden, wird das Substrat in Richtung der Stauchung relativ zum Laser bewegt, während die Maske in entgegengesetzter Richtung bewegt wird. Dabei wird das Geschwindigkeitsverhältnis der Bewegungen so gewählt, dass jeweils das Abbild des Strukturbereiches in der Maske von Laserstrahlung durchsetzt wird, welcher bei der entsprechenden Relativposition zwischen Laser und Substrat auf das Substrat projiziert werden soll. Der Strahlquerschnitt des Laserstrahles ist ebenfalls elliptisch, wobei hier die kleine Halbachse in Bewegungsrichtung ausgerichtet ist.

Aufgabe der Erfindung ist es, ein Verfahren und eine dazu geeignete Vorrichtung zu schaffen, welche es ermöglichen einen Trennriss mittels Laser in eine Substratoberfläche eines Substrates einzubringen, dessen Anfang und Ende nicht an den Substrataußenkanten liegen, und eine Einwirkung der Laserstrahlung über den Anfangs- oder Endpunkt eines Trennrisses hinaus zu unterbinden. Ein Verfahren und eine Vorrichtung gemäß der Erfindung sind in den unabhängigen Ansprüchen 1 und 3 definiert.

Das Verfahren kann durchgeführt werden mit einer Vorrichtung zum Einbringen von Trennrissen in ein Substrat unter Einwirkung eines Laserstrahls mit einem elliptischen Strahlquerschnitt mit einer Werkstückaufnahme zum Aufnehmen eines Substrats, einer Laserquelle zum Emittieren eines Laserstrahls, einem Laserkopf mit einer in Strahlaustrittsrichtung der Laserquelle nachgeordneten Optik, eine optische Achse aufweisend, wobei die optische Achse und damit der Laserstrahl senkrecht auf die Oberfläche des aufgenommenen Substrats gerichtet ist und die Optik dazu ausgelegt ist, den Laserstrahl so zu formen, dass er einen elliptischen Strahlquerschnitt aufweist und auf der Oberfläche des Substrates einen elliptischen Strahlfleck mit einer Strahlflecklänge und einer Strahlfleckbreite bildet, einer Bewegungseinrichtung zum Bewegen des Laserkopfes in einer Bewegungsrichtung entlang eines in das aufgenommene Substrat einzubringenden Trennrisses mit einem Rissanfang und einem Rissende, wobei die Strahlflecklänge entlang der Bewegungsrichtung ausgerichtet ist sowie einer Steuereinrichtung zum Steuern von Verfahrensabläufen. Zwischen der Optik und der Werkstückaufnahme ist in einer Blendenebene senkrecht zur optischen Achse eine mit dem Laserkopf in Verbindung stehende Abblendeinrichtung mit einer Blende vorhanden, deren Blendenöffnung in ihrer Lage und/oder in ihrer Größe entlang der Bewegungsrichtung veränderbar ist, um den Laserstrahl über die Strahlflecklänge kontinuierlich abnehmend oder zunehmend abschatten zu können, womit die Beaufschlagung des Substrats mit dem Laserstrahl vor dem Rissanfang und über das Rissende hinaus vermieden werden kann.

Die Blende ist eine starre Blende mit einem Randbereich, der in Bewegungsrichtung breiter ist als eine Strahlquerschnittslänge in der Blendenebene. Die starre Blende ist an dem Laserkopf entlang der Bewegungsrichtung verschiebbar und die Blendenöffnung ist entsprechend eine starre Blendenöffnung, mit einer Länge größer/gleich der Strahlquerschnittslänge sowie einer Breite größer/gleich einer Strahlquerschnittsbreite in der Blendenebene.

Es ist von Vorteil, wenn sich die Blendenebene unmittelbar hinter der Optik, in einem größtmöglichen Abstand zum Substrat befindet, womit die Blende kleinstmöglich ausgeführt werden kann. Der Laserstrahl wird so auf das Substrat gerichtet, dass er unbeachtet der Blende mit seiner Strahlflecklänge zu Beginn der Strahlführung in Verlängerung des Trennrisses an dem Rissanfang angrenzt und am Ende der Strahlführung in Verlängerung des Trennrisses an dem Rissende angrenzt, wobei der Laserstrahl jedoch durch die vorhandene Blende jeweils vollständig von der Blende abgeschattet wird.

Die abnehmende und zunehmende Abschattung des Laserstrahls erfolgt, indem als Blende eine starre Blende mit einem Randbereich und einer starren Blendenöffnung verwendet wird und mit Beginn der Strahlführung die starre Blende, deren starre Blendenöffnung von Seiten des Trennrisses her an den Rissanfang grenzt gegenüber dem geführten Laserstrahl in Ruhe verharrt, während der Laserstrahl in die starre Blendenöffnung geführt wird, bis ihr Randbereich nicht mehr abschattend wirkt, dann mit einer der Strahlführung entsprechenden Geschwindigkeit mit dem Laserstrahl mitgeführt wird, bis die starre Blendenöffnung auf das Rissende auftrifft und gegenüber dem geführten Laserstrahl wieder in Ruhe verfällt, während der Laserstrahl weiter über den Randbereich geführt wird, bis er vollständig abgeschattet ist.

Vorteilhaft ist das Verfahren, wenn eine abnehmende und/oder zunehmende Abschattung des Laserstrahls nur dann erfolgt, wenn der Rissanfang und/oder das Rissende innerhalb der Oberfläche des Substrats liegt.

Die Erfindung soll nachfolgend anhand von Ausführungsbeispielen näher erläutert werden. In den dazugehörigen Zeichnungen zeigen:
- Fig. 1: eine Prinzipdarstellung der Vorrichtung gemäß einem Beispiel mit einer veränderbaren Blende,
- Fig. 2: den prinzipiellen Ablauf des Verfahrens mit einer Vorrichtung gemäß dem Beispiel,
- Fig. 3: eine Prinzipdarstellung der Vorrichtung gemäß einem Ausführungsbeispiel gemäß der Erfindung mit einer Vorrichtung gemäß dem Ausführungsbeispiel gemäß der Erfindung und
- Fig. 4: den prinzipiellen Ablauf des Verfahrens mit einer starren Blende.

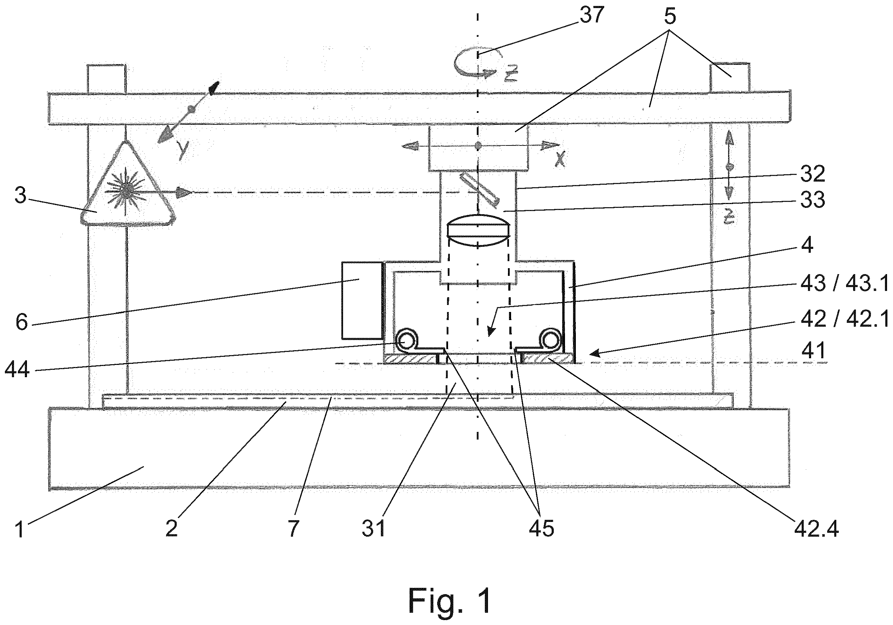

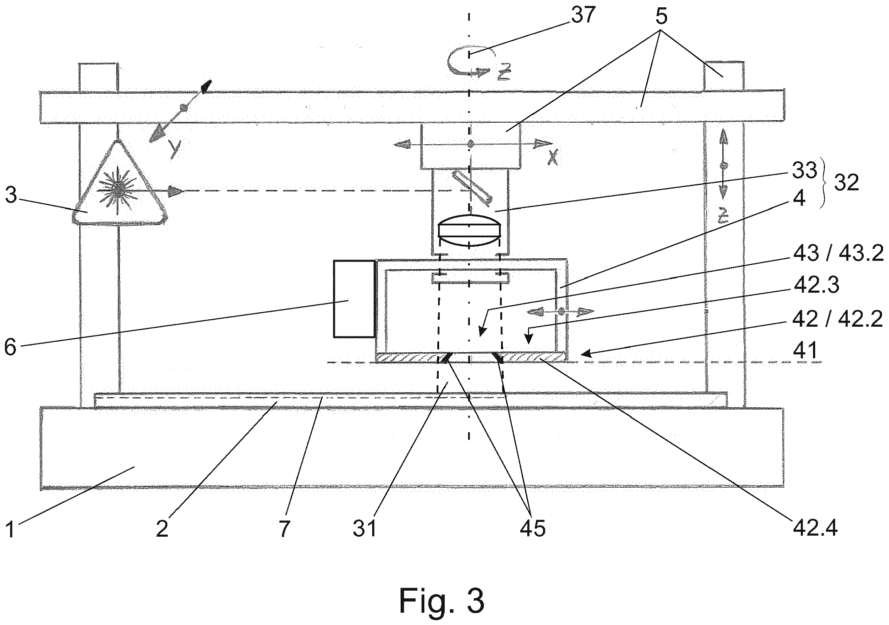

Eine Vorrichtung zur Durchführung des Verfahrens weist grundsätzlich, wie in Fig. 1 und Fig. 3 gezeigt, eine Laserquelle 3, einen Laserkopf 32 mit einer Optik 33, eine Abblendeinrichtung 4, mit einer Blende 42 und eine Werkstückaufnahme 1 auf. Die Optik 33 ist so angeordnet und ausgelegt, dass sie einen von der Laserquelle 3 ausgesendeten Laserstrahl 31 senkrecht auf ein in der Werkstückaufnahme 1 angeordnetes Substrat 2 richtet.

Die beiden nachfolgend beschriebenen Ausführungsbeispiele unterscheiden sich im wesentlichen nur in der Ausführung der Blende 42 und in der festen bzw. beweglichen Anordnung der Abblendeinrichtung 4 an dem Laserkopf 32.

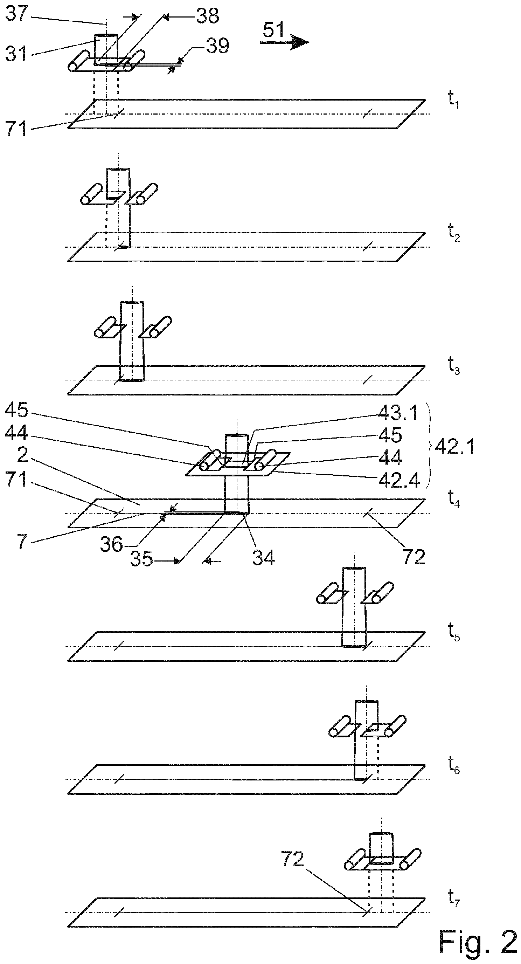

Wie in Fig. 1 und Fig. 2 dargestellt, ist das flächig ausgedehnte Substrat 2 flach auf einer ebenen Werkstückaufnahme 1 aufgelegt. Die Ausrichtung des Substrats 2 in der Werkstückaufnahme 1 erfolgte vorteilhaft in der Horizontalen. In dieser Ausrichtung wird eine einfache Handhabung des Substrats 2 ermöglicht und das Substrat 2 kann auf einfache Weise horizontal gehalten sowie frei von Verspannungen aufgenommen werden.

Um eine definierte Positionierung des Substrats 2 in der Vorrichtung zu erreichen, können an der Werkstückaufnahme 1 seitliche Anschläge vorgesehen werden, an die das Substrat 2 mit dessen Außenkanten angelegt werden kann. Damit kann die Bearbeitung von mehreren gleichartigen Substraten 2 erleichtert werden.

Der Werkstückaufnahme 1 gegenüberliegend, ist eine Bewegungseinrichtung 5 angeordnet. Die Bewegungseinrichtung 5 trägt den zur Führung des Laserstrahls 31 vorgesehenen Laserkopf 32 und ist so ausgelegt, dass deren Bewegungsraum den gesamten Bereich der Werkstückaufnahme 1 abdeckt.

Der von einer Laserquelle 3 erzeugte Laserstrahl 31 wird über die Optik 33 des Laserkopfes 32, entlang einer senkrecht auf die Werkstückaufnahme 1 gerichteten optischen Achse 37 auf die Oberfläche des Substrats 2 gerichtet. Mit der Bewegungseinrichtung 5 kann der Laserkopf 32 linear in allen drei Raumachsen x, y und z und rotierend um die Raumachse z relativ gegenüber dem Substrat 2 bewegt werden.

Der Laserstrahl 31 wird von der Optik 33 in einen Laserstrahl 31 mit elliptischem Strahlquerschnitt geformt, sodass auf der Oberfläche des Substrats 2 ein elliptischer Strahlfleck 34 erzeugt werden kann. Die Abmessungen des elliptischen Strahlflecks 34 können geometrisch über eine in der Hauptachse liegende Strahlflecklänge 35 und eine in der Nebenachse liegende Strahlfleckbreite 36 beschrieben werden. Für die bestimmungsgemäße Verwendung der Vorrichtung ist es vorteilhaft, wenn die Strahlflecklänge 35 ein Vielfaches der Strahlfleckbreite 36 aufweist.

Der Laserkopf 32 wird von der Bewegungseinrichtung 5 so in einer Bewegungsrichtung 51 ausgerichtet und bewegt, dass der elliptische Strahlfleck 34 mit dessen Strahlflecklänge 35 genau in der Bewegungsrichtung 51, entlang eines in die Oberfläche des Substrats 2 einzubringenden Trennrisses 7 orientiert ist.

Es ist dem Fachmann klar, dass eine Bewegung in einer Bewegungsrichtung grundsätzlich offen lässt mit welchem Richtungssinn die Bewegung erfolgen soll. Nachfolgend soll für eine einfach verständliche Beschreibung unter der Bewegungsrichtung 51 eine Richtung mit nur einem Richtungssinn verstanden werden.

Der Optik 33 in Strahlrichtung nachgeordnet und fest mit dem Laserkopf 32 verbunden, ist die Abblendeinrichtung 4, mit der Blende 42, zwischen der Optik 33 und der Werkstückaufnahme 1 angeordnet. Die Blende 42 ist mit einer Steuereinrichtung 6, zu der ein Antrieb gehört, verbunden und weist eine Blendenöffnung 43 auf, deren Relativlage zur Werkstückaufnahme 1 eine orthogonal zur optischen Achse 37 liegende Blendenebene 41 definiert.

Entsprechend der Strahlflecklänge 35 und Strahlfleckbreite 36 des Strahlflecks 34 auf der Oberfläche des Substrats 2 weist der Laserstrahl 31 in der Blendenebene 41 in Abhängigkeit von der Divergenz des Laserstrahls 31 und dem Abstand der Blendenebene 41 von der Oberfläche der Substrates 2 eine Strahlquerschnittslänge 38 und eine Strahlquerschnittsbreite 39 auf.

Ist der Abstand der Blendenebene 41 zur Oberfläche des Substrats 2 nur sehr gering, entspricht die Strahlquerschnittslänge 38 in der Blendenebene 41 auch bei einem in Bewegungsrichtung 51 divergenten Laserstrahl 31 annähernd der Strahlflecklänge 35 und die Blende 42 muss deshalb für eine größtmögliche Strahlquerschnittslänge 38 geeignet entsprechend groß sein, was eine relativ hohe dynamische Belastung zur Folge hat.

Vorteilhaft ist daher die Anordnung der Blende 42 und damit der Blendenebene 41 unmittelbar hinter der Optik 33 in einem größtmöglichen Abstand zum Substrat 2. Die Blende 42 kann damit kleinstmöglich ausgeführt werden und die Dynamik der Blende 42, wie sie nachfolgend an den beiden grundsätzlich unterschiedlichen Blenden 42 erläutert wird, kann auf ein mögliches Minimum, bestimmt durch die geringst mögliche Strahlquerschnittslänge 38, reduziert werden.

Die Blende 42 kann grundsätzlich als eine veränderbare Blende 42.1 oder eine starre Blende 42.2 ausgeführt sein, wobei ihre Wirkungen auf den Laserstrahl gleich sind.

Die Abblendung des Laserstrahls 31 mittels der Blende 42 erfolgt ausschließlich in Richtung der Strahlquerschnittslänge 38 und somit in der Bewegungsrichtung 51, entlang des einzubringenden Trennrisses 7. Die Änderung der Abschattung kann dabei kontinuierlich zunehmend, von einer vollständigen Abschattung bis zu einer vollständigen Freigabe des Laserstrahls 31 und umgekehrt erfolgen.

Gemäß dem Beispiel ist die Blende 42 als eine veränderbare Blende 42.1 und die Blendenöffnung 43 als eine veränderbaren Blendenöffnung 43.1 ausgeführt.

Ergänzend zu Fig. 1 ist die veränderbare Blende 42.1 während ihrer Funktion an verschiedenen Positionen des Trennrisses 7 mit verschiedenen Öffnungszuständen zu den Zeitpunkten t₁ bis t₇ in Fig. 2 gezeigt.

In einer ersten Ausführung wird die veränderbare Blende 42.1 aus einem eine schlitzförmige Öffnung umschließenden Blendenrahmen 42.4 (in Fig. 2 nur zum Zeitpunkt t₄ gezeigt) sowie zwei sich in der Blendenebene 41 gegenüber angeordnete und verstellbare Abblendschieber 44 gebildet. Dabei ist einer der Abblendschieber 44 in der Bewegungsrichtung 51 vor dem Laserstrahl 31 und der zweite hinter dem Laserstrahl 31 angeordnet.

Die Abblendschieber 44 können mittels des Antriebs unabhängig voneinander und relativ gegenüber dem Laserstrahl 31 bewegt werden. Sie werden dazu jalousieartig in Richtung der Strahlquerschnittslänge 38 in den Laserstrahl 31 hinein oder aus diesem heraus bewegt. Jeder der Abblendschieber 44 ist dabei so dimensioniert, dass er den Bereich der Strahlquerschnittslänge 38 vollständig freigeben und auch vollständig abschatten kann. Die Änderung der Abschattung kann stufenlos erfolgen. Die veränderbare Blendenöffnung 43.1 ist somit in der Größe und in der Richtung der abnehmenden oder zunehmenden Abschattung flexibel anpassbar.

Für die Abblendschieber 44 wird ein Material mit guter Wärmeleitung verwendet, das die Transmission des Laserstrahls 31 vollständig unterbinden kann, nicht reflektiert und thermisch stabil ist. Zur Verminderung von Beugungseffekten weisen diese eine mit einem spitzen Winkel versehene Blendenkante 45 auf. Die Abblendschieber 44 können mit den Blendenkanten 45 in der Blendenebene 41 aufeinandertreffen oder so angeordnet werden, dass jeweils ein Abblendschieber 44 oberhalb und ein Abblendschieber 44 unterhalb der Blendeneben 41 aneinander vorbei laufen können. In einer anderen Ausführung der Vorrichtung kann es auch ausreichend sein, nur einen einzelnen Abblendschieber 44 zu verwenden, der in Bewegungsrichtung 51 einseitig vor oder hinter dem Laserstrahl 31 angeordnet ist. Somit kann dann entweder eine zunehmende oder eine abnehmende Abschattung des Laserstrahls 31 gegenüber dem Substrat 2 erfolgen.

Bei allen Ausführung der Vorrichtung mit einer veränderbaren Blende 42.1 ist die Abblendeinrichtung 4 fest mit dem Laserkopf 32 verbunden, sodass die veränderbare Blende 42.1 permanent mit der Optik 33 mitbewegt wird.

Der Ablauf des Verfahrens unter Verwendung einer dem ersten Beispiel entsprechenden Vorrichtung soll anhand der nachfolgenden Verfahrensschritte erläutert werden.

In einem ersten Verfahrensschritt wird ein Substrat 2 flach auf der ebenen Werkstückaufnahme 1 aufgelegt und gegebenenfalls an Anschlägen der Werkstückaufnahme 1 positioniert.

In einem weiteren Verfahrensschritt wird ein Laserstrahl 31 mit einem elliptischen Strahlquerschnitt erzeugt, der auf der Oberfläche des Substrats 2 einen elliptischen Strahlfleck 34, mit einer der Hauptachse des elliptischen Strahlflecks 34 entsprechenden Strahlflecklänge 35 und einer der Nebenachse des elliptischen Strahlflecks 34 entsprechenden Strahlfleckbreite 36, bildet.

Dieser Laserstrahl 31 wird im nachfolgenden Verfahrensschritt senkrecht auf die Oberfläche des aufgenommenen Substrats 2 gerichtet und in einer Bewegungsrichtung 51 entlang eines einzubringenden Trennrisses 7, beginnend an einem Rissanfang 71 hin zu einem Rissende 72, über das Substrat 2 geführt, wobei der Laserstrahl 31 während dieser Bewegung erfindungsgemäß freigegeben oder abgeschattet wird. Die Steuerung dieser Freigabe oder Abschattung erfolgt mit der Steuereinrichtung 6.

Die Strahlflecklänge 35 ist dabei in Richtung des einzubringenden Trennrisses 7 ausgerichtet. Entsprechend der Position des Laserstrahls 31 gegenüber dem Rissanfang 71 und dem Rissende 72 wird dieser zeitweise von einer mit dem Laserstrahl 31 mitgeführten Abblendeinrichtung 4 mit einer eine Blendenebene 41 bildende Blende 42 abgeschattet. Die Abschattung erfolgt so, dass der Laserstrahl 31 vom Rissanfang 71 her abnehmend und zum Rissende 72 hin zunehmend abgeschattet wird. Dadurch wird verhindert, dass das Substrat 2 vor dem Rissanfang 71 und über das Rissenden 72 hinaus mit dem Laserstrahl 31 beaufschlagt wird.

In Abhängigkeit von der Ausführung der Blende 42 kann der Ablauf des Abschattens auf unterschiedliche Weise erfolgen. Im Folgenden soll der Ablauf anhand einer der ersten Ausführung des Beispiels entsprechenden Vorrichtung mit einer veränderbaren Blende 42.1, bestehend aus zwei getrennt ansteuerbaren Abblendschiebern 44 in der gegenüber dem Laserstrahl 31 unbewegten Abblendeinrichtung 4, beschrieben werden. Dabei wird von einem herzustellenden Trennriss 7 ausgegangen, dessen Rissanfang 71 und Rissende 72 nicht an der Kante des Substrats 2, sondern, von der Kante entfernt, im Inneren des Substrates 2 liegt.

Wie in Fig. 2 zum Zeitpunkt t₁ dargestellt, befindet sich der Laserstrahl 31 zu Beginn der Strahlführung, mit dem elliptischen Strahlfleck 34 an den Rissanfang 71 angrenzend, unmittelbar vor dem Rissanfang 71 des Trennrisses 7 (in Fig. 2 durch die Verlängerung des Laserstrahls 31 mit gepunkteter Linie angedeutet). Zu diesem Zeitpunkt t₁ wird der Laserstrahl 31 vollständig durch die veränderbare Blende 42.1 abgeschattet. Dazu ist der dem Laserstrahl 31 in Bewegungsrichtung 51 nachgeordnete Abblendschieber 44 (nachfolgend als hinterer Abblendschieber 44 bezeichnet) soweit in Bewegungsrichtung 51 ausgefahren, dass dessen Blendenkante 45 in der Blendenebene 41 an das in Bewegungsrichtung 51 weisende Ende der Strahlquerschnittslänge 38 angrenzt. In einer senkrechten Projektion der Blendenebene 41 auf die Oberfläche des Substrats 2, nimmt die Blendenkante 45 dabei gleichzeitig eine genau an den Rissanfang 71 angrenzende Position ein.

Der dem Laserstrahl 31 in Bewegungsrichtung 51 vorgeordnete Abblendschieber 44 (nachfolgend als vorderer Abblendschieber 44 bezeichnet) befindet sich zu diesem Zeitpunkt t₁ mit dessen Blendenkante 45 vor dem Laserstrahl 31, vollständig außerhalb der Strahlquerschnittslänge 38, sodass die Blendenkanten 45 beider Abblendschieber 44 sich unmittelbar gegenüberstehend und aneinander angrenzend angeordnet sind.

Mit Beginn der Strahlführung wird der Laserstrahl 31 und die veränderbare Blende 42.1 mit einer vorgegebenen Geschwindigkeit entlang des Trennrisses 7 relativ gegenüber dem Substrat 2 bewegt. Die Blendenkante 45 des hinteren Abblendschiebers 44 verbleibt dabei in einer unveränderten Position gegenüber dem Substrat 2, sodass sich der Laserstrahl 31 relativ zur Blendenkante 45 in die veränderbare Blendenöffnung 43.1 hinein bewegt. Das Verbleiben der Blendenkante 45 in dieser Position wird durch ein zur Geschwindigkeit der Strahlführung synchrones Einfahren des hinteren Abblendschiebers 44 erreicht. Wie in Fig. 2 zum Zeitpunkt t₂ dargestellt, vergrößert sich dabei die veränderbare Blendenöffnung 43.1, sodass die Abschattung des Laserstrahls 31 nach und nach abnimmt. Durch die synchrone Bewegung des hinteren Abblendschiebers 44 wird das Substrat 2 erst ab dem Rissanfang 71 mit dem Laserstrahl 31 beaufschlagt. Der vordere Abblendschieber 44 verbleibt gegenüber dem Laserstrahl 31 in unveränderter Position und wird mit der Strahlführung mitbewegt.

Das zur Strahlführung synchrone Einfahren des hinteren Abblendschiebers 44 wird fortgesetzt, bis der Laserstrahl 31 vollständig freigegeben ist. Diese Position wird in Fig. 2 zum Zeitpunkt t₃ erreicht, sobald sich der Laserstrahl 31 mit der gesamten Strahlquerschnittslänge 38 über die Blendenkante 45 des hinteren Abblendschiebers 44 in die veränderbare Blendenöffnung 43.1 hinein bewegt hat. Ab diesem Zeitpunkt t₃ kann das synchrone Einfahren des hinteren Abblendschiebers 44 beendet werden.

Die weitere Strahlführung entlang des Trennrisses 7 erfolgt entsprechend Fig. 2 zum Zeitpunkt t₄ mit unveränderter Position der Blendenkanten 45 beider Abblendschieber 44 zum Laserstrahl 31.

Sobald der elliptische Strahlfleck 34 auf das Rissende 72 des Trennrisses 7 auftrifft, bzw. die Blendenkante 45 des vorderen Abblendschiebers 44 in einer senkrechten Projektion der Blendenebene 41 auf die Oberfläche des Substrats 2 an das Rissende 72 angrenzt, verbleibt der vordere Abblendschieber 44 in einer unveränderten Position gegenüber dem Substrat 2. Das Verbleiben der Blendenkante 45 in dieser Position wird durch ein zur Geschwindigkeit der Strahlführung synchrones Ausfahren des vorderen Abblendschiebers 44 erreicht. Diese Position wird in Fig. 2 zum Zeitpunkt t₅ erreicht.

Der Laserstrahl 31 bewegt sich dadurch relativ zur Blendenkante 45 des vorderen Abblendschiebers 44 aus der veränderbaren Blendenöffnung 43.1 heraus. Wie in Fig. 2 zum Zeitpunkt t₆ dargestellt, verkleinert sich dabei die veränderbare Blendenöffnung 43.1, sodass die Abschattung des Laserstrahls 31 nach und nach zunimmt. Durch die synchrone Bewegung des hinteren Abblendschiebers 44 wird das Substrat 2, über das Rissende 72 hinaus, nicht mehr mit dem Laserstrahl 31 beaufschlagt.

Die Strahlführung wird beendet, wenn sich der Laserstrahl 31 mit dem elliptischen Strahlfleck 34 an das Rissende 72 angrenzend, unmittelbar hinter dem Rissende 72 des Trennrisses 7 (in Fig. 2 zum Zeitpunkt t₇ durch die Verlängerung des Laserstrahls 31 mit gepunkteten Linien angedeutet), befindet. Zu diesem Zeitpunkt wird der Laserstrahl 31 vollständig durch die veränderbare Blende 42.1 abgeschattet. Dazu ist der vordere Abblendschieber 44 soweit entgegen der Bewegungsrichtung 51 ausgefahren, dass dessen Blendenkante 45 in der Blendenebene 41 an das entgegen der Bewegungsrichtung 51 weisende Ende der Strahlquerschnittslänge 38 angrenzt. Die Blendenkanten 45 beider Abblendschieber 44 sind sich nun wieder unmittelbar gegenüberstehend und aneinander angrenzend angeordnet.

Eine andere Ausführung des Verfahrens wird realisiert, indem nur ein einzelner Abblendschieber 44 zur Abschattung des Laserstrahls 31 verwendet wird. Eine Anwendung ergibt sich beispielsweise bei Substraten 2 bei denen der Trennriss 7 immer an der Außenkante des Substrats 2 startet und nur das Rissende 72 innerhalb der Oberfläche des Substrats 2 liegt. In diesem Fall kann auf die Abschattung des Laserstrahls 31 am Rissanfang 71 verzichtet werden, sodass nur ein vorderer Abblendschieber 44 erforderlich ist, um den Laserstrahl 31 am Rissende 72 abzuschatten.

Der Laserstrahl 31 ist zu Beginn der Strahlführung, in Verlängerung des Trennrisses 7, vor der Außenkante des Substrats 7 positioniert. Die Blendenkante 45 des Abblendschiebers 44 ist vor dem Laserstrahl 31, vollständig außerhalb der Strahlquerschnittslänge 38, angeordnet. Mit Beginn der Strahlführung wird der Laserstrahl 31 ohne Abschattung entlang des Trennrisses 7 auf das Material geführt. Das weitere Verfahren mit der synchronen Abschattung am Rissende 72 entspricht dann dem oben beschriebenen Ablauf.

Das synchrone Abschatten des Laserstrahls 31 wird verwendet, um die Wirkung des Laserstrahls 31 auf der Substratoberfläche ortsabhängig zu begrenzen. Dadurch ist es beispielsweise möglich, Trennrisse 7 in das Substrat 2 einzubringen, die T-förmig aufeinander treffen. T-förmig aufeinandertreffende Trennrisse 7 weisen einen Rissanfang 71 oder ein Rissende 72 auf, die innerhalb der Oberfläche des Substrats 2 an einem quer verlaufenden Trennriss 7 liegen. Mit dem bewegungssynchronen Abschatten des Laserstrahls 31 können zwei Effekte erzielt werden.

Der erste Effekt ist, dass in dem außerhalb des Trennrisses 7 liegenden Bereich des Substrats 2 verhindert wird, dass ein vor dem Rissanfang 71 oder hinter dem Rissende 72 liegender Bereich des Substrats 2 und quer verlaufende Trennrisse 7 mit der thermischen Wirkung des Laserstrahls 31 beaufschlagt und dadurch geschädigt werden. Dies ist insbesondere bei Substraten 2 erforderlich, die eine empfindliche Beschichtung auf der Oberfläche aufweisen.

Ein weiterer Effekt ergibt sich gegenüber Lösungen, die den außerhalb des Trennrisses 7 liegenden Bereich des Substrats 2 dadurch schützen, indem der Laserstrahl 31 erst freigegeben wird, wenn sich der Strahlfleck 34 vollständig im Bereich des Trennrisses 7 befindet. Durch das bewegungssynchrone Abschatten wird erreicht, dass jeder Punkt zwischen Rissanfang 71 und Rissende 72 durch den Laserstrahl 31 mit exakt der gleichen Laserleistung beaufschlagt wird, die auch appliziert werden würde, wenn sich der Laserstrahl 31 ohne Abschattung über den Rissanfang 71 oder das Rissende 72 bewegen würde.

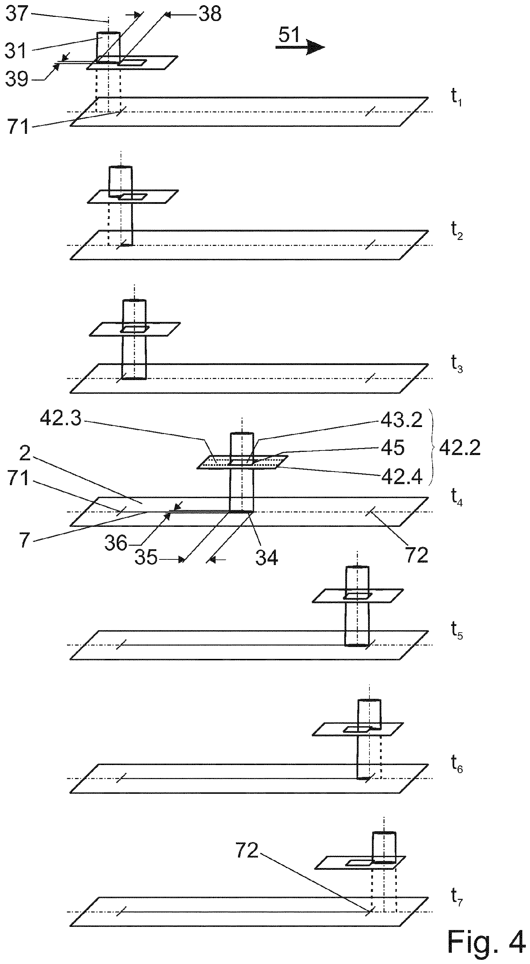

Die Vorrichtung weist gemäß einem in Fig. 3 dargestellten, Ausführungsbeispiel gemäß der Erfindung eine beweglich an dem Laserkopf 32 angeordnete Abblendeinrichtung 4 mit einer Blende 42 in Form einer starren Blende 42.2 und einer Blendenöffnung 43 in Form einer starren Blendenöffnung 43.2 auf. Die Abblendeinrichtung 4 ist, mittels des Antriebs der Steuereinrichtung 6, gegenüber dem Laserkopf 32 in Bewegungsrichtung 51 verschiebbar angebracht. Ergänzend zu Fig. 3 ist die starre Blende 42.2 während ihrer Funktion an verschiedenen Positionen des Trennrisses 7 mit verschiedenen Öffnungszuständen zu den Zeitpunkten t₁ bis t₇ in Fig. 4 gezeigt.

Die starre Blende 42.2 wird durch einen Blendenrahmen 42.4, welcher die starre Blendenöffnung 43.2 umschließt, gebildet. Dabei weist der Blendenrahmen 42.4 Randbereiche 42.3 zur Abschattung auf. Der Blendenrahmen 42.4 ist eine rechteckige Platte aus Aluminium oder einem anderen Material, das als ein Absorber für die verwendete Wellenlänge des Laserstrahls 31 geeignet ist. Zur Reduktion von Reflexionen weist die Oberfläche des Blendenrahmens 42.4 wenigstens in den Randbereichen 42.3 eine reflexionsvermeidende Oberfläche oder Beschichtung auf. Die Stärke des Blendenrahmens 42.4 ist dabei so gewählt, dass Kühlkanäle integriert sein können, die den Durchfluss eines Kühlmediums, vorzugsweise auf Wasserbasis, ermöglichen.

Zentrisch im Blendenrahmen 42.4 ist die starre Blendenöffnung 43.2 angeordnet, wobei sich die Form und Abmessungen der starren Blendenöffnung 43.2 nach der Form und den Abmessungen des Laserstrahls 31 in der Blendenebene 41 richten. Im Fall des elliptisch geformten Laserstrahls 31 ist die starre Blendenöffnung 43.2 als Rechteck ausgeführt, dass mindestens der Strahlquerschnittslänge 38 und der Strahlquerschnittsbreite 39 in der Blendenebene 41 entspricht. Alle Blendenkanten 45 der starren Blendenöffnung 43.2, die zum Abschatten des Laserstrahls 31 verwendet werden, sind zur Vermeidung von Beugungseffekten mit einem Kantenwinkel von ≤70° versehen, wobei die spitzen Blendenkanten 45 auf der Seite des Blendenrahmens 42.4 angebracht sind, die in Richtung der Optik 33 weist.

Die starre Blende 42.2 ist beweglich an dem Laserkopf 32 angebracht, sodass diese entlang der in Bewegungsrichtung 51 orientierten Strahlquerschnittslänge 38 in beide Richtungen verschoben werden kann. Der vollständig durch die starre Blendenöffnung 43.2 hindurchtretende Laserstrahl 31 kann somit entweder in oder entgegen der Bewegungsrichtung 51 zunehmend abgeschattet werden. Zum Abschatten des Laserstrahls 31 wird das Zentrum der starren Blendenöffnung 43.2 relativ zum Laserstrahl 31 bewegt. Das erfolgt mittels des Antriebes der Steuereinrichtung 6 durch motorisches Verschieben der gesamten Abblendeinrichtung 4 an der Optik 33.

Die Abschattung erfolgt durch die beiden Randbereiche 42.3 der starren Blende 42.2. Um den Laserstrahl 31 vollständig abdecken zu können, sind diese in der Bewegungsrichtung 51 auf beiden Seiten der starren Blendenöffnung 43.2 so dimensioniert, dass sie mindestens der Strahlquerschnittslänge 38 des Laserstrahls 31 in der Blendenebene 41 entsprechen. Die starre Blende 42.2 weist damit eine Gesamtlänge von mindestens der dreifachen Strahlquerschnittslänge 38 des Laserstrahls 31 in der Blendenebene 41 auf.

Die Bewegung der starren Blende 42.2 gegenüber dem Laserstrahl 31 kann anhand von drei wesentlichen Positionen beschrieben werden. In Bearbeitungsrichtung 51 gesehen, kann der Blendenrahmen 42.4 eine vordere Endposition, eine Mittelposition und eine hintere Endposition einnehmen. In der vorderen Endposition ist die starre Blendenöffnung 43.2 außerhalb des Laserstrahls 31, in Bewegungsrichtung 51 vor dem Laserstrahl 31, positioniert. Der Laserstrahl 31 wird in dieser Position vollständig von dem der starren Blendenöffnung 43.2 in Bewegungsrichtung 51 nachfolgenden Randbereich 42.3 abgeschattet. In der Mittelposition befindet sich das Zentrum der starren Blendenöffnung 43.2 genau auf der optischen Achse 37, sodass der Laserstrahl 31 vollständig freigegeben ist. In der hinteren Endposition ist die starre Blendenöffnung 43.2 wieder außerhalb des Laserstrahls 31 in Bewegungsrichtung 51 hinter dem Laserstrahl 31 positioniert. Der Laserstrahl 31 wird in dieser Position vollständig von dem in Bewegungsrichtung der starren Blendenöffnung 43.2 vorgelagerten Randbereich 42.3 abgeschattet. Diese Positionen und alle Zwischenpositionen können stufenlos eingestellt werden, wobei die abnehmende und zunehmende Abblendung in beiden Richtungen erfolgen kann.

Allen in den Beispiel und Ausführungsbeispiel genannten Arten von Blenden 42 gleich ist, dass die abnehmende und zunehmende Abschattung des Laserstrahls 31 in allen Bewegungsrichtungen 51 synchronisiert mit einer der Strahlführung entsprechenden Geschwindigkeit des Bewegungssystems 5 erfolgt. Eine Unterscheidung erfolgt durch den Aufbau der Abblendeinrichtung 4 und wie dieser oder dessen Komponenten mittels des Antriebes der Steuereinrichtung 6 bewegt werden. Wie erläutert, wird dabei entweder die veränderbare Blende 42.1 geöffnet und geschlossen, während die Abblendeinrichtung 4 relativ zum bewegten Laserstrahl 31 in Ruhe verharrt oder es wird die starre Blende 42.2 relativ zum bewegten Laserstrahl 31 bewegt, wobei die Abblendeinrichtung 4 nach Freigabe und vor Beginn der Abschattung des Laserstrahls 31 relativ zum Laserstrahl 31 in Ruhe verharrt und synchron mit dem Laserstrahl 31 mitbewegt wird.

Ebenfalls allen Arten der Blende 42 gemeinsam ist, dass es auch möglich ist, die Blende in einem großen Abstand zur Oberfläche des Substrats 2 anzuordnen. Die Optik 33 ist dann entweder dazu ausgelegt einen kollimierten Laserstrahl 31 bereit zustellen, der in Bewegungsrichtung 51 im wesentlichen keine Divergenz aufweist oder es erfolgt eine Anpassung des Bewegungsablaufs der Blende 42, die es trotz eines relativ zur Blendenkante 45 bewegten und divergenten Laserstrahls 31 ermöglicht, die Projektion einer Abschattungskante auf die Oberfläche des Substrats 2 statisch an einer Position zu halten.

In einer weiteren Ausführung der Vorrichtung kann auf die Positionierung des Substrats 2 über Anschläge an der Werkstückaufnahme 1 verzichtet werden. Dazu weist der Laserkopf 32 eine Bilderfassungseinrichtung auf, mit der die Umrisse des Substrats 2 mittels einer Kantenerkennung ermittelt werden können.

Ein Verfahren, das mit einer Vorrichtung gemäß des Ausführungsbeispiels gemäß der Erfindung mit einer starren Blende 42.2 ausgeführt wird, entspricht im wesentlichen dem bereits beschriebenen Verfahrensablauf. Unterschiede ergeben sich durch die Bewegung der Abblendeinrichtung 4 mit der starren Blende 42.2 und der starren Blendenöffnung 43.2. Diese Unterschiede sollen im Folgenden beschrieben werde.

Wie in Fig. 4 zum Zeitpunkt t₁ dargestellt, wird der Laserstrahl 31 zu Beginn der Strahlführung vollständig vom Randbereich 42.3 des Blendenrahmens 42.4 abgeschattet. Dazu befindet sich der Blendenrahmen 42.4 in einer solchen Position, dass die starre Blendenöffnung 43.2 dem Laserstrahl 31 in Bewegungsrichtung 51 vorgeordnet ist. Die Strahlquerschnittslänge 38 grenzt dabei in der Blendenebene 41 an die, in Bewegungsrichtung 51 gesehen, hintere Blendenkante 45 (im Folgenden als Hinterkante bezeichnet) an. In einer senkrechten Projektion der Blendenebene 41 auf die Oberfläche des Substrats 2 nimmt die Hinterkante dabei gleichzeitig eine genau an den Rissanfang 71 angrenzende Position ein.

Mit Beginn der Strahlführung verbleibt die Hinterkante gegenüber dem Substrat 2 in einer unveränderten Position, sodass sich der Laserstrahl 31 relativ zur Hinterkante in die starre Blendenöffnung 43.2 hinein bewegt. Das Verbleiben wird durch ein zur Geschwindigkeit der Strahlführung synchrones Bewegen des Blendenrahmens 42.4 gegenüber dem Laserstrahl 31 erreicht. Wie in Fig. 4 zum Zeitpunkt t₂ dargestellt, nimmt durch die Bewegung des Laserstrahls 31 gegenüber der starren Blende 42.2 dessen Abschattung nach und nach ab. Durch die synchrone Bewegung des Blendenrahmens 42.4 wird das Substrat 2 erst ab dem Rissanfang 71 mit dem Laserstrahl 31 beaufschlagt.

Das zur Strahlführung synchrone Bewegen des Blendenrahmens 42.4 wird fortgesetzt, bis der Laserstrahl 31 vollständig freigegeben ist. Diese Position wird in Fig. 4 zum Zeitpunkt t₃ erreicht, sobald sich der Laserstrahl 31 mit der gesamten Strahlquerschnittslänge 38 vor der Hinterkante der starren Blendenöffnung 43.2 befindet. Ab diesem Zeitpunkt kann die synchrone Bewegung des Blendenrahmens 42.4 beendet werden.

Die weitere Strahlführung entlang des Trennrisses 7 erfolgt entsprechend Fig. 4 zum Zeitpunkt t₄ mit unveränderter Position des Blendenrahmens 42.4 gegenüber dem Laserstrahl 31.

Sobald der elliptische Strahlfleck 34 auf das Rissende 72 des Trennrisses 7 auftrifft, bzw. die in Bewegungsrichtung 51 gesehen vordere Blendenkante 45 der starren Blendenöffnung 42.2 (im Folgenden als Vorderkante bezeichnet) in einer senkrechten Projektion der Blendenebene 41 auf die Oberfläche des Substrats 2 an das Rissende 72 angrenzt, verbleibt die Vorderkante in einer unveränderten Position gegenüber dem Substrat 2. Das Verbleiben der Vorderkante in dieser Position wird durch ein zur Geschwindigkeit der Strahlführung synchrones Bewegen des Blendenrahmens 42.4 erreicht. Diese Position wird in Fig. 4 zum Zeitpunkt t₅ erreicht.

Der Laserstrahl 31 bewegt sich dadurch relativ zur Vorderkante aus der starren Blendenöffnung 43.2 heraus. Wie in Fig. 4 zum Zeitpunkt t₆ dargestellt, nimmt die Abschattung des Laserstrahls 31 dadurch nach und nach zu. Durch die synchrone Bewegung des Blendenrahmens 42.4 wird das Substrat 2, über das Rissende 72 hinaus, nicht mehr mit dem Laserstrahl 31 beaufschlagt.

Die Strahlführung kann beendet werden, wenn sich der Laserstrahl 31 mit dem elliptischen Strahlfleck 34 an das Rissende 72 angrenzend, unmittelbar hinter dem Rissende 72 (in Fig. 4 zum Zeitpunkt t₇ durch die Verlängerung des Laserstrahls 31 mit gepunkteten Linien angedeutet) befindet. Zu diesem Zeitpunkt wird der Laserstrahl 31 vollständig vom Randbereich 42.3 des Blendenrahmens 42.4 abgeschattet. Dazu befindet sich der Blendenrahmen 42.4 in einer solchen Position, dass die starre Blendenöffnung 43.2 dem Laserstrahl 31 in Bewegungsrichtung 51 nachgeordnet ist. Die Strahlquerschnittslänge 38 grenzt dabei in der Blendenebene 41 an die Vorderkante an.

### Bezugszeichenliste

- 1: Werkstückaufnahme
- 2: Substrat
- 3: Laserquelle
- 31: Laserstrahl
- 32: Laserkopf
- 33: Optik
- 34: elliptischer Strahlfleck
- 35: Strahlflecklänge
- 36: Strahlfleckbreite
- 37: optische Achse
- 38: Strahlquerschnittslänge in der Blendenebene 41
- 39: Strahlquerschnittsbreite in der Blendenebene 41
- 4: Abblendeinrichtung
- 41: Blendenebene
- 42: Blende
- 42.1: veränderbare Blende
- 42.2: starre Blende
- 42.3: Randbereich
- 42.4: Blendenrahmen
- 43: Blendenöffnung
- 43.1: veränderbare Blendenöffnung
- 43.2: starre Blendenöffnung
- 44: Abblendschieber
- 45: Blendenkante
- 5: Bewegungseinrichtung
- 51: Bewegungsrichtung
- 6: Steuereinrichtung
- 7: Trennriss
- 71: Rissanfang
- 72: Rissende

## Patentansprüche

1. Verfahren zum Einbringen von Trennrissen (7) in ein Substrat (2) unter Einwirkung eines Laserstrahls (31) mit einem elliptischen Strahlquerschnitt mit den Verfahrensschritten:
- Aufnehmen und Positionieren eines Substrats (2) in einer Werkstückaufnahme (1)
- Erzeugen eines Laserstrahls (31) mit einem elliptischen Strahlquerschnitt zum Bilden eines elliptischen Strahlfleckes (34) mit einer Strahlflecklänge (35) und einer Strahlfleckbreite (36) auf der Oberfläche des aufgenommenen Substrats (2), **gekennzeichnet durch** folgende Schritte und Merkmale :
- Richten des Laserstrahls (31) auf das aufgenommene Substrat (2), wobei die Strahlflecklänge (35) in Richtung eines einzubringenden Trennrisses (7), einen Rissanfang (71) und ein Rissende (72) aufweisend, ausgerichtet wird und Führen des Laserstrahls (31) entlang dem einzubringenden Trennriss (7) von dem Rissanfang (71) zu dem Rissende (72) hin, wobei der Laserstrahl (31) durch eine in eine Blendenebene (41) eingebrachte und wenigstens zeitweise mit dem Laserstrahl (31) geführte Blende (42) wenigstens zeitweise, synchronisiert zur Führung des Laserstrahles (31), nämlich vom Rissanfang (71) her abnehmend abgeschattet und zum Rissende (72) hin zunehmend abgeschattet wird, sodass das Substrat (2) vor dem Rissanfang (71) und über das Rissende (72) hinaus nicht mit dem Laserstrahl (31) beaufschlagt wird und, wobei der Laserstrahl (31) so auf das Substrat (2) gerichtet wird, dass er unbeachtet der Blende (42) mit seiner Strahlflecklänge (35) zu Beginn der Strahlführung in Verlängerung des Trennrisses (7) an dem Rissanfang (71) angrenzt und am Ende der Strahlführung in Verlängerung des Trennrisses (7) an dem Rissende (72) angrenzt, wobei der Laserstrahl (31) jedoch durch die vorhandene Blende (42) jeweils vollständig von der Blende (42) abgeschattet wird, wodurch jeder Punkt zwischen dem Rissanfang (71) und dem Rissende (72) durch den Laserstrahl (31) mit der gleichen Laserleistung beaufschlagt wird, die auch appliziert werden würde, wenn sich der Laserstrahl (31) ohne Abschattung über den Rissanfang (71) oder das Rissende (72) bewegen würde,
wobei die abnehmende und zunehmende Abschattung des Laserstrahls (31) erfolgt, indem als Blende (42) eine starre Blende (42.2) mit einem Randbereich (42.3) und einer starren Blendenöffnung (43.2) verwendet wird und mit Beginn der Strahlführung die starre Blende (42.2), deren starre Blendenöffnung (43.2) von Seiten des Trennrisses her an den Rissanfang (71) grenzt gegenüber dem geführten Laserstrahl (31) in Ruhe verharrt, während der Laserstrahl (31) in die starre Blendenöffnung (43.2) geführt wird, bis ihr Randbereich (42.3) nicht mehr abschattend wirkt, dann mit einer der Strahlführung entsprechenden Geschwindigkeit mit dem Laserstrahl (31) mitgeführt wird, bis die starre Blendenöffnung (43.2) auf das Rissende (72) auftrifft und gegenüber dem geführten Laserstrahl (31) wieder in Ruhe verfällt, während der Laserstrahl (31) weiter über den Randbereich (42.3) geführt wird, bis er vollständig abgeschattet ist.

2. Verfahren nach Anspruch 1, **dadurch gekennzeichnet, dass** die abnehmende und/oder zunehmende Abschattung des Laserstrahls (31) nur dann erfolgt, wenn der Rissanfang (71) und/oder das Rissende (72) innerhalb der Oberfläche des Substrats (2) liegt.

3. Vorrichtung zum Durchführen des Verfahrens nach einem der Ansprüche 1 oder 2, mit einem elliptischen Strahlquerschnitt mit
einer Werkstückaufnahme (1) zum Aufnehmen eines Substrats (2),
einer Laserquelle (3) zum Emittieren eines Laserstrahls (31),
einem Laserkopf (32) mit einer in Strahlaustrittsrichtung der Laserquelle (3) nachgeordneten Optik (33), eine optische Achse (37) aufweisend, wobei die optische Achse (37) und damit der Laserstrahl (31) senkrecht auf die Oberfläche des aufgenommenen Substrats (2) gerichtet ist und die Optik (33) dazu ausgelegt ist, den Laserstrahl (31) so zu formen, dass er einen elliptischen Strahlquerschnitt aufweist und auf der Oberfläche des Substrates (2) einen elliptischen Strahlfleck (34) mit einer Strahlflecklänge (35) und einer Strahlfleckbreite (36) bildet,
einer Bewegungseinrichtung (5) zum Bewegen des Laserkopfes (32) in einer Bewegungsrichtung (51) entlang eines in das aufgenommene Substrat (2) einzubringenden Trennrisses (7) mit einem Rissanfang (71) und einem Rissende (72), wobei die Strahlflecklänge (35) entlang der Bewegungsrichtung (51) ausgerichtet ist
sowie einer Steuereinrichtung (6) zum Steuern von Verfahrensabläufen,
**dadurch gekennzeichnet,**
**dass** zwischen der Optik (33) und der Werkstückaufnahme (1) in einer Blendenebene (41) senkrecht zur optischen Achse (37) eine mit dem Laserkopf (32) in Verbindung stehende Abblendeinrichtung (4) mit einer Blende (42) vorhanden ist, deren Blendenöffnung (43) in ihrer Lage entlang der Bewegungsrichtung (51) veränderbar ist, um den Laserstrahl (31) über die Strahlflecklänge (35) kontinuierlich abnehmend oder zunehmend abschatten zu können, womit die Beaufschlagung des Substrats (2) mit dem Laserstrahl (31) vor dem Rissanfang (71) und über das Rissende (72) hinaus vermieden werden kann,
wobei die Blende (42) eine starre Blende (42.2) mit einem Randbereich (42.3) ist, der in Bewegungsrichtung (51) breiter ist als eine Strahlquerschnittslänge (38) in der Blendenebene (41), die starre Blende (42.2) an dem Laserkopf (32) entlang der Bewegungsrichtung (51) verschiebbar ist und die Blendenöffnung (43) entsprechend eine starre Blendenöffnung (43.2) ist, mit einer Länge größer/gleich der Strahlquerschnittslänge (38) sowie einer Breite größer/gleich einer Strahlquerschnittsbreite (39) in der Blendenebene (41).

4. Vorrichtung nach Anspruch 3, **dadurch gekennzeichnet, dass** sich die Blendenebene (41) unmittelbar hinter der Optik (33), in einem größtmöglichen Abstand zum Substrat (2) befindet.

## Claims

1. A method for generating separating fissures (7) in a substrate (2) through action of a laser beam (31) with an elliptical beam cross section, comprising the steps of:
- receiving and positioning a substrate (2) in a workpiece receptacle (1);
- generating a laser beam (31) with an elliptical beam cross section to form an elliptical beam spot (34) with a beam spot length (35) and a beam spot width (36) on the surface of the received substrate (2);
**characterised by** the following steps and features:
- directing the laser beam (31) onto the received substrate (2), wherein the beam spot length (35) is oriented in a direction of a separating fissure (7) which is to be generated and which has a start (71) and an end (72), guiding the laser beam (31) along the separating fissure (7) to be generated from the start (71) of the fissure to the end (72) of the fissure (7), wherein the laser beam (31) is cut off at least periodically, namely decreasingly cut off from the start (71) of the fissure and increasingly cut off toward the end (72) of the fissure, by a diaphragm (42) which is arranged in a diaphragm plane (41) and which is guided at least periodically with the laser beam (31), so that the substrate (2) is not acted upon by the laser beam (31) before the start (71) of the fissure or beyond the end (72) of the fissure, and wherein the laser beam (31) is directed onto the substrate (2) in such a way that, irrespective of the diaphragm (42), the laser beam (31) abuts with its beam spot length (35) on the start (71) of the fissure at the commencement of beam guidance in extension of the separating fissure (7) and abuts with its beam spot length (35) on the end (72) of the fissure at the termination of beam guidance in extension of the separating fissure (7), wherein, as a result of the provided diaphragm (42), the laser beam (31) is cut off completely in each instance by the diaphragm (42), whereby each point between the start (71) of the fissure and the end (72) of the fissure is acted upon by the laser beam (31) with the same laser power that would also be applied if the laser beam (31) moved beyond the start (71) of the fissure or the end (72) of the fissure without being cut off,
wherein decreasing and increasing cutting off of the laser beam (31) is carried out in that a rigid diaphragm (42.2) with an edge region (42.3) and with a rigid diaphragm aperture (43.2) is used as diaphragm (42), and the rigid diaphragm (42.2) whose rigid diaphragm aperture (43.2) abuts on the start (71) of the separating fissure (7) remains stationary relative to the guided laser beam (31) at the commencement of beam guidance, while the laser beam (31) is guided into the rigid diaphragm aperture (43.2) until the edge region (42.3) thereof no longer has a cutting off effect and is then guided along with the laser beam (31) at a speed corresponding to the beam guidance until the rigid diaphragm aperture (43.2) encounters the end (72) of the fissure and then comes to rest again relative to the guided laser beam (31), while the laser beam (31) continues to be guided along the edge region (42.3) until it is completely cut off.

2. The method according to claim 1, **characterised in that** decreasing and/or increasing cutting off of the laser beam (31) only takes place when the start (71) of the fissure and/or the end (72) of the fissure lies within the surface of the substrate (2).

3. A device for carrying out the method according to any one of claims 1 or 2, with an elliptical beam cross section, comprising:
a workpiece receptacle (1) for receiving a substrate (2),
a laser source (3) for emitting a laser beam (31),
a laser head (32) with optics (33) arranged downstream of the laser source (3) in a beam output direction, having an optical axis (37), wherein the optical axis (37) and, therefore, the laser beam (31) are directed perpendicularly onto the surface of the received substrate (2), the optics (33) being configured to shape the laser beam (31) in such a way that it has an elliptical beam cross section and forms an elliptical beam spot (34) on the surface of the substrate (2), said elliptical beam spot (34) having a beam spot length (35) and a beam spot width (36),
a movement device (5) for moving the laser head (32) in a movement direction (51) along a separating fissure (7) which is to be generated in the received substrate (2) and which has a start (71) and an end (72), wherein the beam spot length (35) is oriented along the movement direction (51),
as well as a control device (6) for controlling the process flows, **characterised in that**
a blocking-out device (4) is provided between the optics (33) and the workpiece receptacle (1), in a diaphragm plane (41) perpendicular to the optical axis (37), which communicates with the laser head (32) and which has a diaphragm (42) with an aperture (43) that can be varied with respect to the position thereof along the movement direction (51) in order to cut off the laser beam (31) in a continuously decreasing or increasing manner over the beam spot length (35) so as to prevent the laser beam (31) from impinging on the substrate (2) before the start (71) of the fissure and beyond the end (72) of the fissure,
wherein the diaphragm (42) is a rigid diaphragm (42.2) with an edge region (42.3) which is wider in the movement direction (51) than a beam cross section length (38) in the diaphragm plane (41), the rigid diaphragm (42.2) being displaceable at the laser head (32) along the movement direction (51), and the diaphragm aperture (43) being correspondingly a rigid diaphragm aperture (43.2), with a length that is greater than or equal to the beam cross section length (38) and a width that is greater than or equal to a beam cross section width (39) in the diaphragm plane (41).

4. The device according to claim 3, **characterised in that** the diaphragm plane (41) is located directly behind the optics (33) at the greatest possible distance from the substrate (2).

## Revendications

1. Procédé d'introduction de fissures de séparation (7) dans un substrat (2) sous l'action d'un faisceau laser (31) à section transversale elliptique, ledit procédé comportant les étapes de:
- recevoir et positionner un substrat (2) dans un récepteur de pièces (1),
- générer un faisceau laser (31) à section transversale elliptique pour produire une tâche de faisceau elliptique (34) d'une longueur (35) et d'une largeur (36) sur la surface du substrat reçu (2),
**caractérisé par** les étapes et caractéristiques suivantes:
- diriger le faisceau laser (31) sur le substrat reçu (2), en orientant la longueur (35) de la tâche de faisceau en direction d'une fissure de séparation (7) à introduire, cette dernière présentant un début (71) et une fin (72), et guider le faisceau laser (31) le long de la fissure de séparation (7) à introduire, de son début (71) jusqu'à sa fin (72), le faisceau laser (31) étant coupé, au moins temporairement, de manière synchronisée avec le guidage du faisceau laser (31), par un diaphragme (42) introduit dans un plan de diaphragme (41) et guidé au moins temporairement avec le faisceau laser (31), cette coupure décroissant dès le début (71) et augmentant vers la fin (72), de sorte que le faisceau laser (31) ne frappe pas sur le substrat (2) avant le début (71) ni au-delà de la fin (72), le faisceau laser (31) étant dirigé sur le substrat (2) de sorte qu'il avoisine, irrespectivement du diaphragme (42), le début (71) par sa longueur (35) de la tâche de faisceau, au début du guidage du faisceau en prolongation de la fissure de séparation (7), et avoisine la fin (72) par sa longueur (35) de la tâche de faisceau à la fin du guidage du faisceau en prolongation de la fissure de séparation (7), le faisceau laser (31) étant coupé complètement à chaque fois par le diaphragme (42) présent, de sorte que le faisceau laser (31) frappe chaque point entre le début (71) et la fin (72) d'une puissance laser égale à celle appliquée si le faisceau laser (31) se déplaçait sur le début (71) ou la fin (72) de la fissure de séparation (7) sans être coupé,
la coupure décroissante ou augmentante du faisceau laser (31) se produisant en ce que l'on utilise comme diaphragme (42) un diaphragme rigide (42.2), qui présente une région périphérique (42.3) et une aperture de diaphragme rigide (43.2) et en ce que le diaphragme rigide (42.2) dont l'aperture de diaphragme rigide (43.2) avoisine le début (71) du côté de la fissure de séparation reste en repos par rapport au faisceau laser (31) guidé, lorsque le faisceau laser (31) est guidé dans l'aperture de diaphragme rigide (43.2), jusqu'à ce que sa région périphérique (43.2) n'ait plus d'effet de coupure, et soit ensuite guidé avec le faisceau laser (31) à une vitesse correspondant au guidage du faisceau, jusqu'à ce que l'aperture de diaphragme rigide (43.2) atteigne la fin (72) et rentre en repos par rapport au faisceau laser (31) guidé, pendant que le faisceau laser (31) est encore guidé sur la région périphérique (42.3) jusqu'à ce qu'il soit complètement coupé.

2. Procédé selon la revendication 1, **caractérisé en ce que** la coupure décroissante et/ou augmentante du faisceau laser (31) se produit seulement lorsque le début (71) et/ou la fin (72) de la fissure de séparation se trouve dans la surface du substrat (2).

3. Dispositif destiné à exécuter le procédé selon l'une quelconque des revendications 1 ou 2, de section transversale elliptique, comportant
un récepteur de pièces (1) pour recevoir un substrat (2),
une source laser (3) pour l'émission d'un faisceau laser (31),
une tête laser (32) comportant une optique (33) disposée en aval en direction de sortie du faisceau de la source laser (3) et présentant un axe optique (37), cet axe optique (37) et, par conséquent, le faisceau laser (31) étant dirigés verticalement sur la surface du substrat reçu (2) et l'optique (33) étant configurée à former le faisceau laser (31) de sorte qu'il présente une section transversale elliptique et produise une tâche de faisceau (34) elliptique sur la surface du substrat (2), cette tâche de faisceau (34) présentant une longueur (35) et une largeur (36),
un dispositif de déplacement (5) destiné à déplacer la tête laser (32) dans une direction de déplacement (51) le long d'une fissure de séparation (7) à introduire dans le substrat reçu (2), ladite fissure de séparation (7) présentant un début (71) et une fin (72) et la longueur (35) de la tâche de faisceau étant orientée selon la direction de déplacement (51),
ainsi qu'un dispositif de commande (6) pour la commande de procédures,
**caractérisé en ce que**
l'on prévoit, entre l'optique (33) et le récepteur de pièces (1), dans un plan de diaphragme (41) perpendiculaire à l'axe optique (37), un dispositif de tamisage (4), qui est en communication avec la tête laser (32) et comporte un diaphragme (42) dont l'aperture (43) est variable en position selon la direction de déplacement (51), afin de pouvoir couper le faisceau laser (31) de manière continuellement décroissante ou augmentante sur la longueur (35) de la tâche de faisceau, évitant ainsi l'action du faisceau laser (31) sur le substrat (2) avant le début (71) et au-delà de la fin (72) de la fissure de séparation (7),
le diaphragme (42) étant un diaphragme rigide (42.2) avec une région périphérique (42.3) dont la largeur en direction de déplacement (51) est supérieure à une longueur de section transversale (38) du faisceau dans le plan de diaphragme (41), le diaphragme rigide (42.2) étant déplaçable sur la tête laser (32) selon la direction de déplacement (51) et l'aperture de diaphragme (43) étant, par conséquent, une aperture de diaphragme rigide (43.2) d'une longueur supérieure/égale à la longueur de section transversale (38) du faisceau et d'une largeur supérieure/égale à une largeur de section transversale (39) du faisceau dans le plan de diaphragme (41).

4. Dispositif selon la revendication 3, **caractérisé en ce que** le plan de diaphragme (41) se trouve immédiatement derrière l'optique (33), à une distance maximale du substrat (2).
